Europäisches Patentamt

European Patent Office

Office européen des brevets

(11) Numéro de publication: **0 005 403**
**A1**

## (12) DEMANDE DE BREVET EUROPEEN

(21) Numéro de dépôt: **79400279.0**

(51) Int. Cl.²: **H 03 B 5/18, H 01 P 1/16**

(22) Date de dépôt: **02.05.79**

(30) Priorité: **03.05.78 FR 7813090**

(71) Demandeur: **"THOMSON-CSF", 173, boulevard Haussmann, F-75360 Paris Cedex 08 (FR)**

(43) Date de publication de la demande: **14.11.79 Bulletin 79/23**

(72) Inventeur: **Castera, Jean-Paul, "Thomson-CSF" - SCPI 173, bld Haussmann, 75360 Paris Cedes 08 (FR)**

(74) Mandataire: **Wang, Pierre et al, "THOMSON-CSF" - SCPI 173, bld. Haussmann, F-75360 Paris Cedex 08 (FR)**

(84) Etats contractants désignés: **DE GB IT NL**

(54) **Oscillateur monomode en hyperfréquences, accordable par variation d'un champ magnétique.**

(57) L'oscillateur monomode en hyperfréquences, accordable par variation d'un champ magnétique, utilise la propagation d'ondes magnétostatiques à la surface d'un matériau magnétique.

L'oscillateur comprend deux lignes à retard de longueurs différentes formées à la surface du matériau magnétique dont l'une des extrémités est commune et matérialisée par un transducteur (3), chacune des autres extrémités étant matérialisée par un deuxième (41) et un troisième transducteur (42). Les deux lignes sont bouclées par l'intermédiaire d'un amplificateur unique (7). Le choix des deux longueurs permet d'obtenir l'écart entre modes voulu, de façon qu'il y ait un mode d'oscillation unique compris dans la bande passante des transducteurs, dans une gamme d'accord prédéterminée.

Application aux dispositifs nécessitant un signal dont la fréquence soit de l'ordre de 2 GHz et puisse varier de plusieurs centaines de MHz, comme les radars, les appareils de mesure.

00005403

1
OSCILLATEUR MONOMODE EN HYPERFREQUENCES, ACCOR-
DABLE PAR VARIATION D'UN CHAMP MAGNETIQUE

L'invention concerne un oscillateur monomode en hyperfréquences utilisant les ondes magnétostatiques pouvant se propager à la surface d'une couche mince de matériau magnétique sous l'influence d'un champ magnétique extérieur, la fréquence d'oscillation pouvant être réglée par variations du champ magnétique.

Les oscillateurs accordables grâce à un champ magnétique comprenant une ligne à retard formée dans une couche mince magnétique ont déjà été réalisés. Ces oscillateurs utilisent la propagation dans la ligne à retard d'ondes magnéto-élastiques provenant de l'intéraction des ondes magnétiques créées par un champ magnétique dans une couche magnétique et des ondes élastiques créées par effet piézoélectrique entre un transducteur d'entrée auquel une tension électrique est appliquée et un transducteur de sortie, l'espace compris dans la couche magnétique entre les deux transducteurs constituant la ligne à retard. La propagation des ondes magnéto-élastiques étant liée à des déplacements de matière, la fréquence d'oscillation que l'on peut obtenir en bouclant les deux transducteurs par l'intermédiaire d'un am-

00005403

2

plificateur est de l'ordre de 100 MHz et excède
difficilement 1 GHz. D'autre part, la capacité
d'accord par variation du champ magnétique est
très faible, de l'ordre de 1 à 5 % environ.

Pour obtenir des fréquences d'oscillation se situant approximativement dans la gamme 1-10 GHz, on est conduit à utiliser un autre type de propagation possible dans un matériau magnétique qui est celui des ondes magnétostatiques. Ces ondes dûes au mouvement de l'aimantation dans le matériau sont de type purement magnétique. On les excite au moyen d'un transducteur dans lequel circule un courant hyperfréquence. Les transducteurs sont dans ce cas des conducteurs dont une extrémité est reliée à la masse et l'autre reçoit ou émet un courant électrique. La propagation de ces ondes étant liée à des déplacements de spins, en reliant les deux transducteurs par l'intermédiaire d'un amplificateur, on peut obtenir un oscillateur fonctionnant à des fréquences de l'ordre du GHz. Des considérations simples sur les conditions d'oscillation conduisent à constater que pour un champ magnétique donné, il existe une infinité de modes d'oscillation équidistants en fréquence. Pour obtenir un oscillateur monomode, il faut faire en sorte que la bande passante des transducteurs ne recouvre qu'un seul mode. Il n'est pas souhaitable d'augmenter exagérément l'écart entre modes car plus cet écart augmente, plus le coefficient de qualité de l'oscillateur devient mauvais. On peut envisager alors de diminuer la bande passante des transducteurs. Un moyen connu est d'utiliser pour l'entrée et la sortie de la ligne à retard plusieurs transducteurs placés en parallèle.

La bande passante est très inférieure à celle
d'un transducteur unique et on arrive ainsi à sélectionner un seul mode. Mais un problème se pose lorsque l'on fait varier le champ magnétique
pour régler la fréquence d'oscillation : lorsque
le champ magnétique varie, les modes se déplacent
en fréquence et la bande passante se déplace
aussi, mais pas à la même vitesse. Pour que le
mode sélectionné reste dans la bande passante,
celle-ci étant de faible valeur, il faut que la
variation du champ magnétique soit très faible,
ce qui limite la possibilité d'accord à une centaine de MHz.

L'invention préconise un oscillateur
comprenant à la surface de la même couche magnétique deux lignes à retard à ondes magnétostatiques, de longueurs différentes. Un moyen simple
de former ces deux lignes est de disposer sur la
couche trois transducteurs, les deux lignes étant
constituées par l'espace compris entre l'un des
transducteurs et chacun des deux autres, c'est-
à dire qu'elles ont en commun soit le transducteur d'entrée, soit le transducteur de sortie.
Les deux lignes sont ensuite bouclées par l'intermédiaire d'un amplificateur unique. Les modes
d'oscillation de l'oscillateur à deux lignes
correspondent aux fréquences pour lesquelles coïncident les modes des deux lignes prises séparément. En déterminant convenablement les longueurs
des deux lignes, on peut choisir à volonté l'écart entre modes, ce qui supprime la nécessité de
réduire la bande passante des transducteurs. La
gamme d'accord de la fréquence d'oscillation peut
alors s'étendre sur plusieurs centaines de MHz,

4

voire 1 à 2 GHz.

D'autres caractéristiques et avantages de l'invention apparaîtront à l'aide de la description ci-après et des figures qui l'accompagnent parmi lesquelles :

- la figure 1 représente une ligne à retard à ondes magnétostatiques de surface ;

- la figure 2 est un schéma d'oscillateur de type connu comprenant une ligne à retard ;

- la figure 3 est un diagramme de féquences donnant les modes d'oscillation de l'oscillateur de la figure 2 ;

- la figure 4 est la courbe représentative de la fonction de transfert de la boucle de l'oscillateur de la figure 2 ;

- la figure 5 est une courbe montrant les inconvénients d'oscillateurs de type connu ;

- la figure 6 est un schéma d'oscillateur selon l'invention ;

- la figure 7 est un diagramme de fréquences montrant les modes d'oscillation de l'oscillateur de la figure 6 ;

- la figure 8 représente un mode de réalisation de l'invention ;

- la figure 9 est un schéma explicatif de choix des paramètres de l'oscillateur selon l'invention.

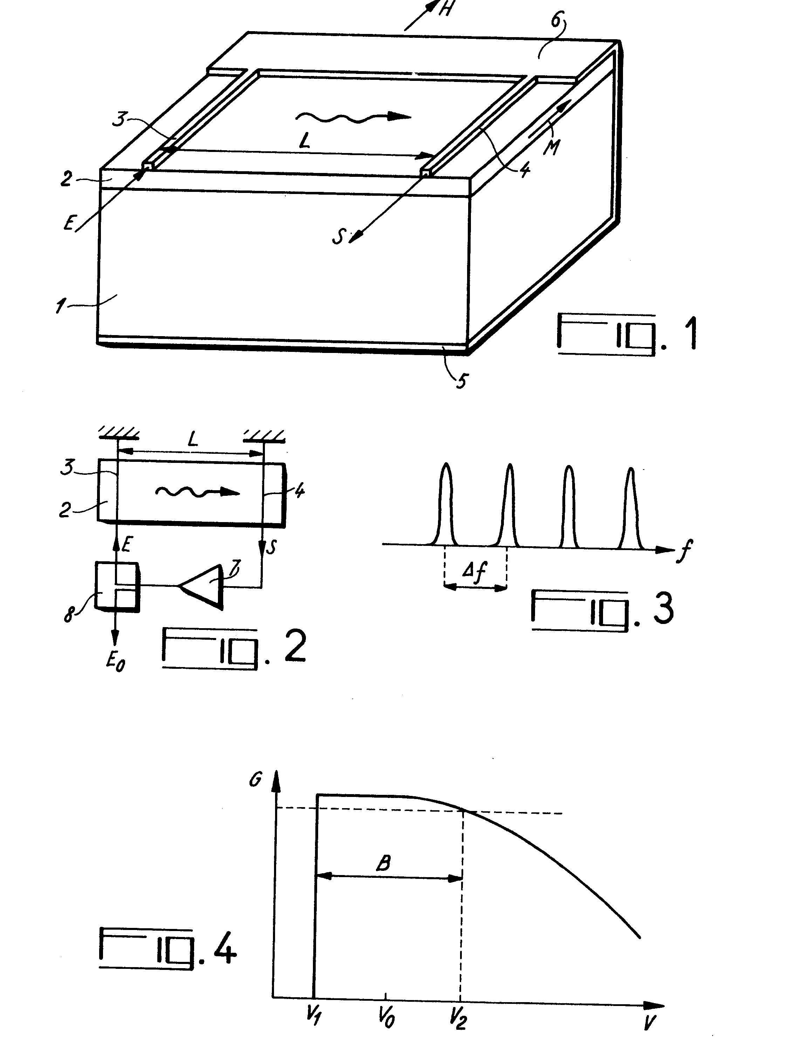

Une ligne à retard à ondes magnétostatiques de surface est représentée sur la figure 1. Elle est formée dans un milieu magnétique aimanté d'aimantation M auquel on applique un champ magnétique constant H. On peut déduire des équations de Maxwell que l'interaction entre le champ appliqué et l'aimantation permet la propagation dans le matériau d'ondes de surface. Le dispositif de la figure 1 comprend un substrat non magnétique 1, par exemple un grenat de gadolinium-gallium (G.G.G) sur lequel est déposée une couche mince 2 d'un grenat ferrimagnétique, obtenu par exemple par croissance par épitaxie en phase liquide sur le grenat de gadolinium-gallium. Ce grenat ferrimagnétique peut être un grenat d'yttrium-fer (Y.I.G.) pur ; ce matériau présente de faibles pertes magnétiques, si bien que les ondes de surface générées sont utilisables dans des dispositifs en structure planaire tels que ligne à retard, résonateur, oscillateur ...

Le couplage de ces ondes se fait au moyen de transducteurs qui sont des bandes métalliques déposées sur la couche 2. La ligne à retard de la figure 1 est formée entre un transducteur d'entrée 3 et un transducteur de sortie 4. L'une des extrémités de chaque transducteur est reliée à une couche métallique 5 située à l'opposé de la couche ferrimagnétique 2 par rapport au substrat 1 et qui constitue la masse du dispositif. La couche métallique 5 se prolonge en recouvrant l'une des faces transversales du substrat 1 et une partie 6 de la surface extérieure de la couche ferrimagnétique 2, ce qui permet la jonction avec les transducteurs 3 et 4. A l'autre extrémité du transducteur 3 est appliqué un signal d'entrée E dont la fréquence f est dans le domaine des hyperfréquences (de l'ordre de gigahertz). A l'autre extrémité du transducteur 4, on récupère un signal S après propagation entre les deux transducteurs. Ceux-ci se trouvant en court-circuit, le courant électrique y est maximum. Il produit une induction magnétique de fréquence f qui a un mouvement de précession autour du champ magnétique

6

extérieur H. Cette précession se propage entre les deux transducteurs avec une vitesse de propagation V qui dépend des caractéristiques du matériau ferrimagnétique et du champ magnétique H. En fonction de la longueur L entre les deux transducteurs, le courant S récupéré présente un retard $\tau$ par rapport au courant d'entrée E. La ligne à retard représentée sur la figure peut être utilisée dans des dispositifs variés, et notamment pour un oscillateur.

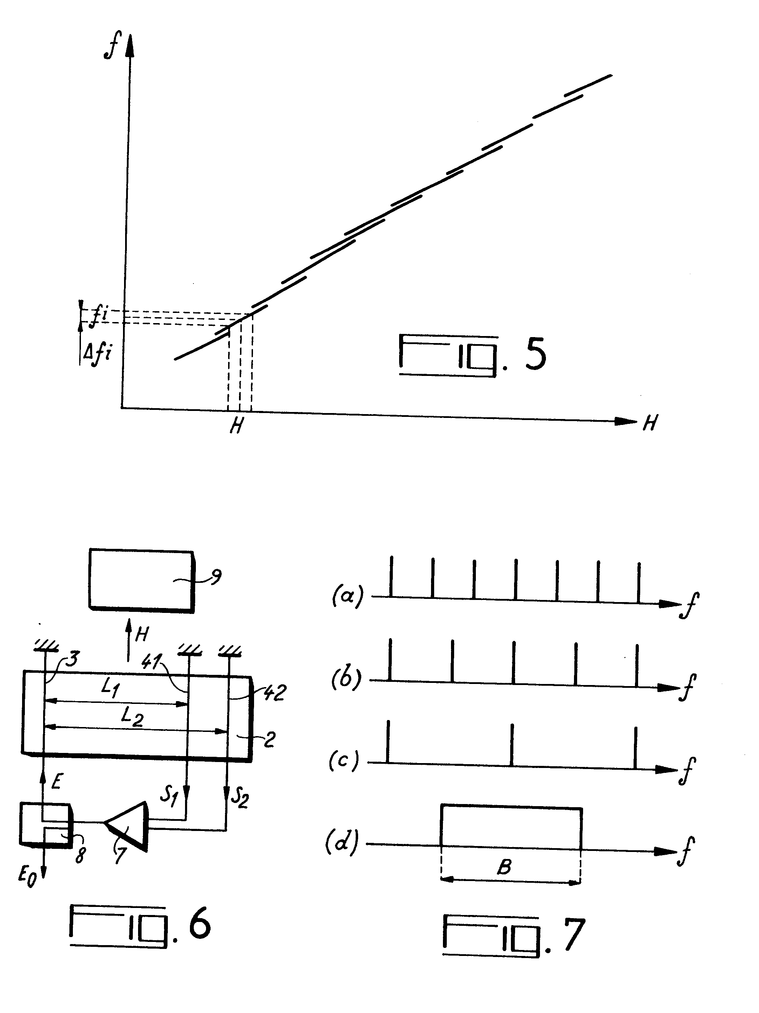

Un schéma simplifié d'oscillateur de type connu est représenté sur la figure 2. Sur la couche 2 sont disposés les transducteurs 3 et 4 ayant chacun une extrémité reliée à la masse. L'autre extrémité du transducteur 4, qui fournit le courant S, est reliée à l'entrée d'un amplificateur 7 qui fournit le courant E appliqué à l'autre extrémité du transducteur 3. Un coupleur 8 permet en outre de recueillir une fraction $E_0$ du courant E. Les conditions d'oscillation d'un tel dispositif sont que le gain de boucle soit supérieur à 1 et que le déphasage total apporté par la ligne à retard, l'amplificateur et les câbles de liaison soit un multiple entier de $2\pi$. f étant la fréquence d'oscillation, $\tau$ le retard de la ligne à retard, et $\theta_e$ le déphasage apporté par l'amplificateur et les câbles, cette dernière condition s'écrit $\theta_e + 2\pi f\tau = n\, 2\pi$ , n étant un entier. Le déphasage $\theta_e$ est équivalent à un retard $t_0 = \frac{\theta_e}{2\pi f}$ ; le dispositif de la figure 2 est capable d'osciller à toutes les fréquences de la forme $f = \frac{n}{t_0 + \tau}$, comprises dans la bande passante des transducteurs 3 et 4 et telles que le gain de boucle soit supérieur à 1.

7

La figure 3 représente le spectre de fréquences de l'oscillateur. L'écart entre les fréquences de deux modes voisins est égal à
$\Delta f = \dfrac{1}{t_0 + \tau}$. Les modes sont donc d'autant plus
rapprochés que le retard $\tau$ est grand. Par ailleurs,
le coefficient de qualité de l'oscillateur est
proportionnel à $\tau$.

La figure 4 est un diagramme représentatif
de la fonction de transfert de la boucle de l'oscillateur, c'est-à-dire du gain de boucle G en
fonction de la fréquence v. Pour obtenir une oscillation, il faut que le gain de la boucle G soit
supérieur à 1, donc que le gain de l'amplificateur soit supérieur aux pertes d'insertion. La
fonction de transfert possède deux fréquences de
coupure $v_1$ et $v_2$. La valeur de $v_2$ est fonction de
la largeur des transducteurs. On sait en effet
qu'un transducteur de largeur b permet le couplage des ondes de vecteur d'onde compris entre 0
et $\dfrac{\pi}{b}$. D'autre part, les pertes d'insertion
augmentent avec la fréquence. Ceci est dû à l'accroissement du retard des ondes avec la fréquence,
ce qui provoque l'augmentation des pertes de
propagation. En ajustant le gain de l'amplificateur, de façon que le gain de boucle soit égal
à 1 au voisinage de la fréquence $v_2$, on obtient
un oscillateur dont le gain de boucle ne varie
pas plus de 3dB sur toute la plage d'oscillation.
Cette plage est centrée sur une fréquence $v_0$ et
a pour largeur $B = v_2 - v_1$.

Des valeurs typiques obtenues avec un
oscillateur comprenant une couche de YIG de 10
$\mu$m d'épaisseur, des transducteurs de largeur
50 $\mu$m, de longueur 3mm et distants de L = 1 cm,

8

le champ magnétique appliqué étant H = 200 Oe sont B ≠ 600 MHz, $v_0$ ≠ 2 GHz, $t_0$ + τ ≠ 120ns, Δ f ≠ 9 MHz. La comparaison entre B et Δ f montre que cet oscillateur n'est pas monomode. Pour le rendre monomode, un 1er moyen serait d'augmenter la valeur de Δ f en diminuant la longueur L mais cette solution est à proscrire car il faudrait augmenter très fortement Δ f, or le coefficient de qualité diminue lorsque Δ f augmente. Un autre moyen serait de réduire la bande passante en utilisant à l'entrée et à la sortie de la ligne à retard plusieurs transducteurs en parallèle. Avec 6 transducteurs de 100 μm de largeur, placés en parallèle, on obtient une bande passante de 35 MHz. Cette méthode convient pour un oscillateur dont la fréquence est fixée ou est à accorder sur une plage réduite. L'objet de l'invention est d'obtenir un oscillateur monomode, largement accordable, utilisant la facilité d'accord par variation du champ magnétique. Or, le retard ayant une variation sensiblement proportionnelle à celle de H, la variation $\Delta f_i$ de la fréquence $f_i$ d'un mode donné est telle que $\dfrac{\Delta f_i}{f_i} = \dfrac{\Delta \tau}{\tau + t_0}$ . La bande passante se déplace également. On peut estimer son déplacement d'après la variation de la fréquence centrale $v_0$ telle que $\dfrac{\Delta v_0}{v_0} = \dfrac{\Delta \tau}{\tau}$ . Le déplacement de la bande passante est donc plus rapide que celui des modes d'oscillation. Si l'on centre la bande passante sur une valeur $f_i$ pour un champ magnétique donné, de façon à sélectionner le seul mode de fréquence $f_i$, pour une autre valeur du champ magnétique, la bande passante s'étant déplacée par rapport au spectre des modes, il se peut que la bande passante recouvre une autre fréquence, ou bien deux fréquences $f_j$, et $f_k$, ou au contraire qu'aucune fréquence ne se trouve dans la bande passante, si celle-ci est très réduite. Une courbe de variation donnant la (ou les) fréquence d'oscillation f en fonction du champ magnétique H est représentée sur la figure 5. Cette courbe est formée de tronçons de droites séparés par des sauts, correspondant à l'écart $\Delta$ f. La plage d'accord en l'absence de saut est très réduite : environ 100 MHz avec les valeurs données ci-dessus.

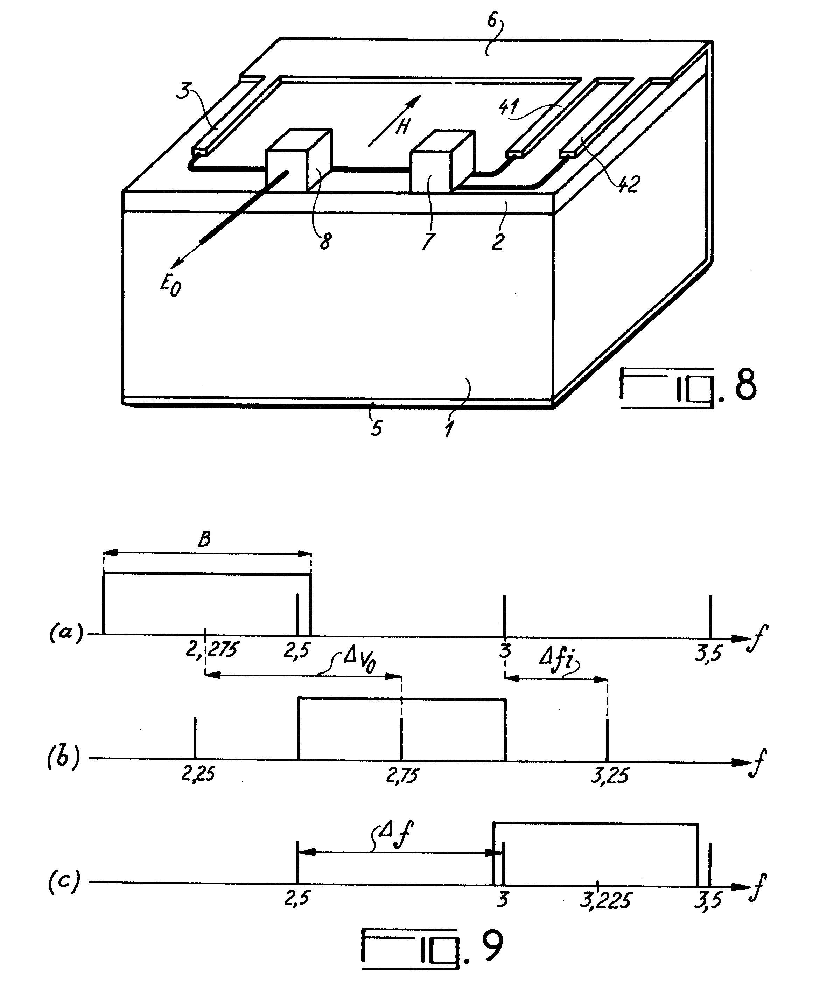

La figure 6 représente schématiquement un oscillateur selon l'invention, monomode et accordable sur une plage de plusieurs centaines de MHz. Cet oscillateur comprend deux lignes à retard mises en parallèle dans une même boucle d'oscillation avec un amplificateur unique. Sur la couche ferrimagnétique 2 sont disposés trois transducteurs : un transducteur d'entrée 3 recevant un courant E comme précédemment et deux transducteurs de sortie 41 et 42 fournissant des courants $S_1$ et $S_2$. L'une des extrémités de chaque transducteur est reliée à la masse. On obtient ainsi sur la même surface deux lignes à retard : une ligne de longueur $L_1$ entre les transducteurs 3 et 41, apportant un retard $T_1$ et une ligne de longueur $L_2$ supérieure à $L_1$ entre les transducteurs 3 et 42, apportant un retard $T_2 > T_1$. Les signaux $S_1$ et $S_2$ sont additionnés sur l'entrée d'un amplificateur 7. Une faible fraction $E_0$ du signal obtenu à la sortie de l'amplificateur est recueillie à la sortie de l'oscillateur, le reste forme le signal d'entrée E de la ligne à retard. L'extraction du signal $E_0$ se fait au moyen du

10

coupleur 8. La couche 2 étant soumise à un champ magnétique H provenant de moyens électromagnétiques $^9$, on peut faire varier les retards $\Upsilon_1$ et $\Upsilon_2$ en faisant varier l'intensité du champ magnétique. Un oscillateur selon l'invention peut également comporter deux lignes de longueurs $L_1$ et $L_2$ ayant un transducteur de sortie commun, la sortie de l'amplificateur étant reliée au transducteur d'entrée de chaque ligne. La disposition des deux lignes à retard admet de nombreuses variantes : sur la même couche mais n'ayant pas de parties communes ; ayant chacune leurs propres transducteurs d'entrée et de sortie ; sur des couches différentes éventuellement formées de matériaux différents, juxtaposées ou non, etc.. Quelque soit son mode de réalisation, le fonctionnement d'un oscillateur à deux lignes à retard de retards différents peut être expliqué à partir des spectres de fréquences de la figure 7 correspondant à une valeur donnée de H. En (a) est représenté le spectre de fréquence d'un oscillateur qui serait formé à partir d'une ligne à retard $\Upsilon_1$, dont le retard total est $\Upsilon_1 + t_{o1}$. Les modes sont espacés de $\Delta f = \dfrac{1}{\Upsilon_1 + t_{01}}$. En (b) est représenté le spectre de fréquence d'un oscillateur qui serait formé à partir d'une ligne à retard $\tau_2$, dont le retard total est $\Upsilon_2 + t_{o2}$. Les modes sont espacés de $\Delta f_2 = \dfrac{1}{\Upsilon_2 + t_{o2}}$. En (c) est représenté le spectre de fréquences de l'oscillateur de la figure 6. On constate que les modes d'oscillation sont ceux pour lesquels les fréquences coïncident dans les spectres (a) et (b). Dans le cas de la figure, $\dfrac{\Upsilon_2 + t_{o2}}{\Upsilon_1 + t_{o1}} = 2/3$ , on a un écart entre mode $\Delta f = 3 \Delta f_1 = 2 \Delta f_2$. L'utilisation de deux lignes à retard a donc permis d'augmenter l'écart entre les modes

11

sans perdre sur le coefficient de qualité. En (d) est schématisée la bande passante des deux lignes à retard. Pour que l'oscillateur soit accordable, il faut que la variation de H ne détruise pas la coincidence des fréquences entre les spectre (a) et (b), c'est-à-dire que $\dfrac{\Delta \tau_1}{\tau_1 + to_1} = \dfrac{\Delta \tau_2}{\tau_2 + to_2}$ or, $\dfrac{\Delta \tau_1}{\Delta \tau_2} = \dfrac{\tau_1}{\tau_2}$ ; d'où $\dfrac{\tau_1}{\tau_2} \dfrac{+ to_1}{+ to_2} = \dfrac{\tau_1}{\tau_2} = \dfrac{L_1}{L_2}$ .

en choisissant convenablement la valeur du rapport $\dfrac{\tau_2 + to_2}{\tau_1 + to_1}$, on peut déterminer à volonté l'écart entre les modes de l'oscillateur de façon que cet écart suffisamment grand en fonction de la bande passante. Le centrage de celle-ci par rapport à un mode particulier doit permettre l'accord de la fréquence d'oscillation par variation du champ magnétique H sur une plage importante (du même ordre de grandeur que l'écart entre les modes).

La figure 8 représente un mode de réalisation de l'oscillateur selon l'invention. Il comprend un substrat GGG 1 de 500 μm d'épaisseur sur la surface duquel on a fait croître par épitaxie en phase liquide une couche de YIG pur 2 de 10 μm d'épaisseur. La couche est parallèle à un plan facile d'orientation du GGG (1,1,1). On obtient ainsi une couche d'aimantation uniforme. Le champ magnétique appliqué H est parallèle à ce plan et à l'aimantation M de la couche. Les moyens électromagnétiques 9 sont classiques (il peut s'agir par exemple d'un aimant permanent) et n'ont pas été représentés, pour alléger la figure. Les transducteurs 3, 41, 42 sont des bandes conductrices très étroites (de l'ordre de 50 μm de large), afin d'obtenir une bande passante large de l'ordre de 500 MHz). Ces bandes sont obtenues

12

par pulvérisation sous vide d'une couche d'aluminium, de cuivre, d'or ... d'épaisseur 5 um et photogravure. La longueur des bandes est de 3 mm. Leur orientation sur la couche 2 détermine l'angle entre la direction de propagation et le champ H, choisi de façon à obtenir les interactions maximales. Les distances entre les transducteur, $L_1$ et $L_2$, peuvent être très précises (à quelques $\mu$m près) grâce aux techniques de masquage et photogravure. La surface libre du substrat 1 et une de ses faces transversales est recouverte d'une couche conductrice 5, qui peut être faite du même matériau que les transducteurs, reliée à la couche 6 formée à la surface de la couche 2 en même temps que les transducteurs. L'amplificateur peut être un circuit intégré contenu dans un boitier et situé sur la couche de YIG 2. Il s'agit, par exemple d'un amplificateur classique constitué à l'aide de transistors à effet de champ. Le coupleur directionnel 8 est lui aussi situé sur la couche de YIG. Les liaisons entre les transducteurs 3, 41, 42, l'amplificateur 7 et le coupleur 8 se font par des câbles coaxiaux dont la gaine est reliée à la couche de masse 5.

Le choix des longueurs $L_1$ et $L_2$ dépend, on l'a vu, des performances souhaitées pour l'oscillateur. Un ordre de grandeur des différentes grandeur physiques intervenant dans ce choix peut être donné et découle d'une réalisation de l'oscillateur avec $L_1$ = 10 mm et $L_2$ = 15 mm. En appliquant un champ magnétique H de 180 Oe, on a mesuré une fréquence d'oscillation $f_o$ = 2,1 GHz et des retards $t_{01} + \Upsilon_1$ = 77 ns et $t_{02} + \Upsilon_2$ =115 ns.

13

Les valeurs correspondantes de $\Delta f_1$ et $\Delta f_2$ sont $\Delta f_1 = \Delta f_2 = 13$ MHz et $\Delta f_2 = 8,69$ MHz. L'écart entre modes de l'oscillateur décrit est $\Delta f = 26$ MHz. On constate par ailleurs que la fréquence d'oscillation est proportionnelle au champ H. Ces valeurs de $L_1$ et $L_2$ ne sont données que pour vérifier le fonctionnement d'un oscillateur comportant 2 lignes à retard. Mais elles ne conviennent pas pour un oscillateur monomode, en effet, l'écart $\Delta f$ est beaucoup plus faible que la bande passante qui vaut 500 MHz avec des transducteurs de 50 $\mu$m de large.

La figure 9 est un diagramme explicatif de la méthode préconisée pour choisir les différents paramètres de l'oscillateur. Dans le cas de l'exemple choisi pour la figure, la bande pas- santeB vaut 500 MHz et l'écart entre modes est également de 500 MHz. On souhaite pouvoir accorder la fréquence d'oscillation sur une plage de 500 MHz entre 2,5 GHz et 3 GHz. La figure représente en (a), (b), (c) des diagrammes de fré- quence pour 3 valeurs $H_1$, $H_2$, $H_3$ du champ magné- tique correspondant respectivement à des fréquences d'oscillation de 2,5 GHz, 2,75 GHz, 3 GHz. La fréquence centrale $v_0$ de la bande passante ayant une variation plus grande en fonction de H que la fréquence d'oscillation $f_i$ d'un mode donné, on choisit le centrage de la bande passante par rapport au mode d'oscillation de façon que la fréquence d'oscillation pour le champ $H_1$ (2,5 GHz) soit située dans les hautes fréquences de la bande et pour le champ $H_3$ (3 GHz) dans les bases fréquences de la bande, tandis que pour $H_2$, la fréquence d'oscillation (2,75 GHz) se trouve au

00005403

14

centre de la bande . C'est ainsi qu'on a obtenu
en agissant sur le gain de l'amplificateur, respectivement pour $H_1$, $H_2$, $H_3$, $v_0$ égal à 2,275 GHz,
2,75 GHz, 3,225 GHz. La valeur choisie pour B
permet dans tous les cas de ne sélectionner qu'un
seul mode. Pour $\Delta f_i$ = 500 MHz, on a donc
$\Delta v_0$ = 950 MHz, ce qui conduit a la relation :

$$\frac{\tau_1 + t_{01}}{1} = \frac{\tau_2 + t_{02}}{\tau_2} = \frac{950}{950} = 1,9 .$$

Les valeurs de $\Delta f_1$ et $\Delta f_2$ sont telles que
$\Delta f$ = 500 MHz = $n_1$ $\Delta f_1$ = $n_2$ $\Delta f_2$ où $n_1$ et $n_2$ sont
des entiers premiers entre eux. Par exemple,
$n_1$ = 100 et $\Delta f_1$ = 5 MHz ; $n_2$ = 111 et $\Delta f_2$ = 4,5MHz
on en déduit $t_{01}$ + $\tau_1$ = 200 ns et $t_{02}$ + $\tau_2$ = 222 ns.
La relation ci-dessus impose $\tau_1$ = 105 ns et $\tau_2$ =
117 ns, les valeurs $t_{01}$ = 95 ns et $t_{02}$ = 105 ns
peuvent être obtenues grâce aux retards apportés
par l'amplificateur et les câbles. Pour les mesurer, il suffit d'enlever les lignes à retard
du circuit et de mesurer les écarts de fréquence
d'oscillation obtenues pour les deux boucles. Les
longueurs $L_1$ et $L_2$ sont ajustées pour obtenir les
retards $\tau_1$ et $\tau_2$ ci-dessus, le rapport $\frac{L_2}{L_1}$ valant
1,11. Elles sont de l'ordre de 15 mm. Pour ajuster la fréquence d'oscillation entre 2,5 GHz et
3 GHz, il suffira de faire varier le champ magnétique entre environ 210 oe et 260 oe. Toutes
ces valeurs ne sont données qu'à titre d'exemple
et pour montrer comment on peut réaliser un oscillateur monomode accordable selon l'invention.
Les applications de l'invention sont celles des
oscillateurs fonctionnant dans le domaine des
hyperfréquences comme les radars, les appareils
de mesure ... La simplicité du dispositif proposé,

15

son faible encombrement dû à la technologie employée et sa grande capacité d'accord le rendent
particulièrement avantageux.

1

R E V E N D I C A T I O N S

1. Oscillateur monomode en hyperfréquence, accordable par variation d'un champ magnétique, caractérisé en ce qu'il comprend deux lignes à retard propageant des ondes magnétostatiques de surface constituées dans un matériau magnétique disposé en couche, des moyens électromagnétiques permettant de soumettre les deux lignes à un champ magnétique extérieur, les deux lignes étant bouclées sur elles-mêmes par un amplificateur et présentant des retards différents tels que la boucle oscille à une fréquence pure f, l'oscillateur comprenant en outre des moyens d'extraction d'un signal de fréquence f, cette fréquence variant dans une gamme prédéterminée lorsque l'intensité du champ magnétique extérieur varie.

2. Oscillateur selon la revendication 1, caractérisé en ce que le matériau magnétique est un grenat d'yttrium-fer déposé en couche sur un substrat formé d'un grenat de gadolinium-gallium..

3. Oscillateur selon l'une des revendications 1 et 2, caractérisé en ce que les deux lignes sont constituées par l'espace compris entre un transducteur d'entrée et un transducteur de sortie constitués par des bandes métalliques déposées sur le matériau magnétique dont une extrémité est reliée à une masse commune et l'autre est reliée respectivement à la sortie et à l'entrée de l'amplificateur.

4. Oscillateur selon la revendication 3, caractérisé en ce que les deux lignes sont situées sur la même couche, ont des longueurs différentes et une partie commune.

2

5. Oscillateur selon la revendication 4, caractérisé en ce que les deux lignes à retard ont une extrémité commune correspondant à un transducteur d'entrée unique, les signaux issus des deux autres transducteurs étant additionnés à l'entrée de l'amplificateur.

6. Oscillateur selon la revendication 4, caractérisé en ce que les deux lignes à retard ont une extrémité commune correspondant à un transducteur de sortie unique, la sortie de l'amplificateur étant reliée à chacun des deux autres transducteurs.

7. Oscillateur selon l'une des revendication 1 à 6, caractérisé en ce que les moyens d'extraction du signal de fréquence f comprennent un coupleur dont l'entrée est reliée à la sortie de l'amplificateur, dont une des sorties est reliée à la deuxième extrémité de chaque ligne à retard et dont une autre sortie fournit le signal.

00005403

FIG. 1

FIG. 2

FIG. 3

FIG. 4

FIG. 5

FIG. 6

FIG. 7

00005403

FIG.8

FIG.9

## DOCUMENTS CONSIDERES COMME PERTINENTS

| Catégorie | Citation du document avec indication, en cas de besoin, des parties pertinentes | Revendication concernée |
|---|---|---|
| | <u>US - A - 4 028 639</u> (HAGON et al.)<br><br>  * Colonne 2, ligne 40 - colonne 8, ligne 47; figures 1-5 *<br><br>-- | 1,2,7 |
| | 1975 "IEEE MTT-S INTERNATIONAL MICROWAVE SYMPOSIUM"(12-14 mai 1975, PALO ALTO)<br>New York<br>HAWORTH:"A Magnetostatic Delay Line Oscillator", pages 371-372.<br><br>  * Page 371, colonne de gauche, ligne 1 - colonne de droite, ligne 5, figure 1 *<br><br>-- | 1,2,7 |
| | ELECTRONICS LETTERS, vol. 12, no. 9, 29 avril 1976,<br>London<br>MILLER et al.: "Tunable Magnetostatic Surface-Wave Oscillator" pages 209-210.<br><br>  * En entier *<br><br>-- | 1,2,7 |
| | ELECTRONICS LETTERS, vol. 13, no. 19, 15 septembre 1977<br>London<br>VOLLUET: "Surface-Acoustic-Wave Oscillator Tuned by Magneto-elastic Effect", pages 588-590.<br><br>  * Page 588, ligne 1 - page 589, colonne de gauche, ligne 7; figure 1 *<br><br>-- | 1,2,7 |
| | <u>DE - A - 2 345 262</u> (MARCONI)<br><br>  * Page 3, ligne 1 - page 5, ligne 9; figure 2 *              ./. | 1,4,5 |

**CLASSEMENT DE LA DEMANDE (Int. Cl.²)**

H 03 B 5/18
H 01 P 1/16

**DOMAINES TECHNIQUES RECHERCHES (Int. Cl.²)**

H 03 B 5/18
        5/32
        5/36
H 01 P 1/16

**CATEGORIE DES DOCUMENTS CITES**

X: particulièrement pertinent

A: arrière-plan technologique

O: divulgation non-écrite

P: document intercalaire

T: théorie ou principe à la base de l'invention

E: demande faisant interférence

D: document cité dans la demande

L: document cité pour d'autres raisons

&: membre de la même famille, document correspondant

| | |
|---|---|
| X | Le présent rapport de recherche a été établi pour toutes les revendications |

| Lieu de la recherche | Date d'achèvement de la recherche | Examinateur |
|---|---|---|
| La Haye | 14-06-1979 | D'HONDT |

OEB Form 1503.1  06.78

| | DOCUMENTS CONSIDERES COMME PERTINENTS | | CLASSEMENT DE LA DEMANDE (Int. Cl.³) |
|---|---|---|---|
| Catégorie | Citation du document avec indication, en cas de besoin, des parties pertinentes | Revendication concernée | |
| P | 8TH EUROPEAN MICROWAVE CONFERENCE 78 (4-8 septembre 1978, Paris) SEVENOAKS (GB) CASTERA et al."Magnetostatic Surface Wave Oscillators and Resonators", pages 658-662 <br><br> * Page 658, ligne 1 - page 660, ligne 5, figure 3 * <br><br> -- | 1-5 | |
| P | 1978 DIGESTS OF THE INTERMAG CONFERENCE (9-12 mai 1978, Florence) New York CASTERA: "A Magnetostatic Surface-Wave Oscillator using two Paths" page 29-6. <br><br> * En entier * <br><br> ---- | 1-5 | **DOMAINES TECHNIQUES RECHERCHES (int. Cl.³)** |